# EUROPEAN PATENT APPLICATION

(11) **EP 0 612 867 A1**
(43) Date of publication of application: **31.08.1994**
(21) Application number: 94102606.4
(22) Date of filing: 22.02.1994
(51) Int. Cl.: C30B 15/14, C30B 15/00

(54) **Inert gas rectifying/blowing apparatus for single crystal pulling device**

(30) Priority: 23.02.1993 JP 33110/93
(71) Applicant: SHIN-ETSU HANDOTAI COMPANY LIMITED, Chiyoda-ku Tokyo (JP)
(72) Inventor: Mizuishi, Koji, c/o Isobe Plant, Annaka-shi, Gunma 379-01 (JP); Toyoshima, Masaru, c/o Isobe Plant, Annaka-shi, Gunma 379-01 (JP); Ohiwa, Hideo, c/o Isobe Plant, Annaka-shi, Gunma 379-01 (JP)
(74) Representative: Schneck, Herbert, Dipl.-Phys., Dr.

(57) **Abstract**

The gas emission ring pipe 50 is positioned concentrically with the rectifying cylinder 38 connected at the upper end to the opening at the upper end of the main chamber 12 and aligned concentrically with the single crystal 36 pulled up. A plurality of holes 50a for gas emission are formed on the inner side of the ring pipe 50 in the direction of the radius. The inert gas G1 flows down inside the rectifying cylinder 38 and the cooling inert gas G2 is supplied via the gas delivery pipe 52 from outside of the main chamber 12 into the ring pipe 50. Since the cooling inert gas G2 is emitted through the emission holes 50a of the ring pipe 50, the lower portion of the single crystal can be cooled safely and efficiently and the vertical temperature gradient of the single crystal 36 near the solid/liquid interface is steeper, resulting in improved growth rate of the single crystal 36.

## Description

### BACKGROUND OF THE INVENTION

The present invention relates to an inert gas rectifying/blowing apparatus for a single crystal pulling device, which rectifies the flow of inert gas with a rectifying cylinder positioned concentrically with the growing single crystal and which also blows upon the lower part of the single crystal with cooling inert gas.

When growing an Si single crystal by pulling it up from an Si melt in a quartz crucible, volatile SiO is generated by the reaction between the quartz crucible and the Si melt. This SiO is deposited on the edge of the crucible, the Si single crystal, the pull shaft and the inner wall of the chamber. The SiO which is deposited on the pull shaft that is raised while rotating, is scraped off by the sealing ring for airtightness at the upper lid, and falls into the melt below. This causes defects in the growing single crystal. To deal with this problem, a method in which a rectifying cylinder is hung down concentrically with the pull shaft over the melt surface into which Ar gas is injected from above so that it will flow down into the rectifying cylinder causing the SiO which has evaporated from the melt surface to be discharged from the lower part of the chamber along with the Ar gas, has been disclosed (Second Publication No. 54-6511 of Japanese Patent Application).

Another method, which attempts to create an effect similar to that provided by a rectifying cylinder without actually providing a rectifying cylinder has also been disclosed, in which a ring pipe formed with a plurality of holes on its outer side in the direction of the radius is provided concentrically with the single crystal 36 over the melt surface. Ar gas is supplied to this ring pipe to be emitted toward the outside in the direction of the radius through these holes, and at the same time, Ar gas is flown down from above (First Publication No. 4-46088 of Japanese Patent Application).

Another method has been disclosed in which the vertical temperature gradient of the single crystal near the solid/liquid interface is increased to improve the crystal growth rate by adding a collar, which is formed by folding the lower end of the rectifying cylinder outward and upward (First Publication No. 64-65086 of Japanese Patent Application).

In contrast, alternative methods to adding a collar to the lower end of the rectifying cylinder wherein Ar gas that has been cooled with liquid nitrogen is inducted into the rectifying cylinder to flow downward (First Publication No. 53-8374 of Japanese Patent Application) and by cooling the rectifying cylinder with water (First Publication No. 61-68389 of Japanese Patent Application) to improve the crystal growth rate have also been disclosed.

However, in the method that employs the ring pipe, the growing portion of the crystal is heated by radiant heat and, as it is not possible to cool the growing portion of the crystal with Ar gas at the same time, the crystal growth rate cannot be improved.

The method that has a collar added onto the lower end of the rectifying cylinder has the advantage of allowing a very simple structure. However, the improvement in crystal growth rate is limited.

Since the diameter of single crystals has become larger recently, the single crystal pulling speed has been reduced and there is need for an improvement of this rate to reduce production costs.

Also, in the method that uses cooling Ar gas or the method in which the rectifying cylinder is cooled with water, since Ar gas is heated by radiant heat and so on from the material melt when the Ar gas flows downward inside the rectifying cylinder, the efficiency with which the lower end portion of the single crystal 36 is cooled to improve the crystal growth rate is not good. In order to improve crystal growth rate with this type of method, a very high flow rate of Ar gas is required and it is, therefore, not economical. When the Ar gas flow rate is set at a high level, turbulence occurs on the material melt and the success rate of growing of the thin neck portion of the crystal of approximately 3 to 5 mm in diameter that follows the seed crystal is particularly reduced. Also, when cooling the rectifying cylinder with water, the efficiency with which the inert gas is cooled is poor. Furthermore, if water enters the material melt due to cooling water pipe damage, for example, there will be an explosion, and the method is, therefore, unsafe.

### SUMMARY OF THE INVENTION

Accordingly, an object of the present invention is to provide an inert gas rectifying/blowing apparatus for a single crystal pulling device in which the single crystal growth rate can be improved efficiently, significantly and safely without requiring a large flow rate of Ar gas.

According to the present invention, there is provided a inert gas rectifying/blowing apparatus for a single crystal pulling device which includes: a large diameter main chamber; a small diameter sub-chamber connected to an opening at upper end of the large diameter main chamber; and a crucible for containing material melt, the crucible being within the main chamber, whereby a single crystal is grown by immersing a seed crystal in the material melt and by pulling the seed crystal upwards vertically, the inert gas rectifying/blowing apparatus comprising: a rectifying cylinder, an opening at upper end of which is connected to the opening at the upper end of the main chamber and which surrounds the single crystal in concentricity with the single crystal, and through which inert gas flows downward; a ring pipe provided concentrically with and inside lower end of the rectifying cylinder, the ring pipe having a plurality of holes or a slit for gas emission formed inside the ring pipe in radius direction; and a gas supply pipe for supplying cooling inert gas from the outside of the chamber into the ring pipe for emission inside the main chamber.

According to the present invention, it is possible to prevent a volatile gas, for example, the volatile SiO generated through the reaction between the Si material melt and the quartz crucible from being deposited on the inner circumferential surface of the crucible, the single crystal, the seed holder, the pull shaft and the like when pulling up the single crystal because the volatile SiO is discharged through the flow of the inert gas. Also, since the quantity of SiO evaporating from the material melt increases due to the flow of this inert gas, and the oxygen concentration in the Si single crystal is thereby reduced, oxidation-induced defects and swirl defects are reduced.

In addition to the major effects presented by the rectifying cylinder and the inert gas as described earlier, the following secondary effect is produced by the rectifying cylinder and the inert gas: as the inert gas passes down so as to surround the single crystal, the single crystal is cooled, resulting in an improved crystal growth rate.

However, since the inert gas is heated when it flows down inside the rectifying cylinder, the flow rate of the inert gas must be sufficient to allow such a secondary effect to function adequately, and it is , therefore, not economical. Furthermore, if the flow rate of the inert gas is increased, the surface of the material melt becomes turbulent, and the success rate, particularly in the formation of the thin neck portion of the single crystal that follows the seed crystal, is reduced.

On the other hand, during the growth of the singe crystal, as the cooling inert gas is emitted out through the gas emission holes of the ring pipe, it is possible to cool the lower portion of the single crystal safely and efficiently. As a result, the vertical temperature gradient of the single crystal near the solid/liquid interface becomes steep and the growth rate of the single crystal is improved. With this, it becomes possible either to increase the diameter of the single crystal or to improve the pulling speed of the single crystal. Also, since it is not necessary to set the flow rate of the inert gas at a high level, it is possible to prevent the surface of the material melt from becoming turbulent due to the flow of the inert gas and it becomes possible to increase the success rate, particularly in the formation of the narrow portion of the single crystal that follows the seed crystal.

In the first form of the present invention, the holes for gas emission formed in the ring pipe for gas emission, have the same diameter, whereas the pitch of the holes becomes smaller as their distance increases from the connecting portions of the gas supply pipe with the ring pipe for gas emission, in order to cool the circumferential surface of the single crystal evenly.

With this structure, since it is possible to cool the circumferential surface of the single crystal more evenly, unevenness on the surface of the single crystal become smaller. Also, as the holes for gas emission a all have the same diameter, the ring pipe for gas emission can be produced easily.

In the second form of the present invention, the holes for gas emission formed in the ring pipe for gas emission all have the same pitch. In order to cool the circumferential surface of the single crystal evenly, the diameter of the holes become larger as their distance increases from the connecting portions of the gas supply pipes with the ring pipe for gas emission.

With this structure too, since it is possible to cool the circumferential surface of the single crystal more evenly, unevenness on the surface of the single crystal become smaller.

In the third form of the present invention, the holes or the slit formed in the ring pipe for gas emission are formed uniformly along inner circumference of the ring pipe in radius direction of the ring pipe for gas emission, the gas supply pipe have a gas distribution ring pipe of approximately the same diameter as the ring pipe for gas emission, the gas distribution ring pipe being arranged concentrically with the ring pipe for gas emission and provided with a plurality of communicating holes that communicate with the ring pipe for gas emission; and a gas linear pipe being connected at its one end to the gas distribution ring pipe and lead to outside of the chamber, whereby the cooling inert gas is substantially uniformly distributed in a the ring pipe for gas emission when the cooling inert gas enters the ring pipe for gas emission from the gas linear pipe via the gas distribution ring pipe.

This structure facilitates design and production of the ring pipe for gas emission and, moreover, makes it possible to cool the circumferential surface of the single crystal even more evenly.

In the fourth form of the present invention, the rectifying cylinder is provided with a collar at the lower end, that is circular in cross section and that extends outward and upward from the lower end.

In this structure, although the radiant heat is absorbed by the outer surface of the collar, since the collar is cooled by the inert gas, the temperature inside the lower portion of the rectifying cylinder 38 is lower than it is in a structure without the collar, resulting in a further improved growth rate for the single crystal.

### BRIEF DESCRIPTION OF THE DRAWINGS

FIG. 1 is a schematic view of the semiconductor single crystal growing apparatus using the pull method;
FIG. 2A is a perspective view of the cooling inert gas blowing apparatus in the first embodiment;
FIG. 2B being a cross sectional view of the ring pipe 50 and the single crystal 36 in FIG. 2A;
FIG. 3 is a perspective view of the cooling inert blowing apparatus in the second embodiment;
FIG. 4A is a perspective view of the cooling inert gas blowing apparatus in the third embodiment; and
FIG. 4B is a plan view of the gas distribution ring pipe 80 in FIG. 4A.

### DESCRIPTION OF THE PREFERRED EMBODIMENT

### First Embodiment

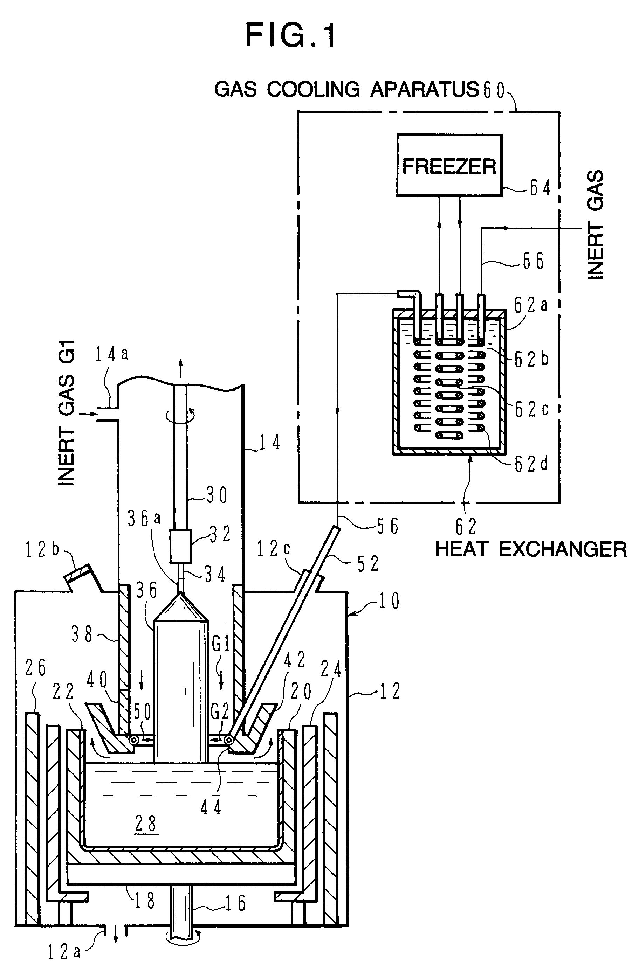

FIG. 1 shows a schematic view of the single crystal growing apparatus using the pull method.

The chamber 10 consists of the lower main chamber 12 and the upper sub-chamber 14. The Ar gas supply port 14a is formed in the side wall of the sub-chamber 14 and the Ar gas exhaust port 12a is formed in the bottom of the main chamber 12. Also, an inspection hole 12b for observation of the single crystal is provided at the shoulder portion of the main chamber 12.

Inside the main chamber 12, a table 18 is secured onto the upper end of the shaft 16 which can be elevated and rotated at the same time. On the table 18, a graphite crucible 20 is provided and a quartz crucible 22 is fitted inside the graphite crucible 20. The graphite crucible 20 is surrounded by the heater 24 which is surrounded by the graphite insulating wall 26. When polycrystal Si is placed inside the quartz crucible 22 and power is supplied to the heater 24, the Si is dissolved to become the melt 28.

The seed crystal 34 is held by the seed holder 32 at the lower end of the pull shaft 30 that is moved vertically along the axis of the sub-chamber 14. By lowering the pull shaft 30 to immerse the seed crystal 34 in the melt 28, and by rotating it in the opposite direction of the rotation direction of the shaft 16 as indicated by the arrow in the figure while it is being pulled up, the single crystal 36 is grown.

The opening at the upper end of the graphite rectifying cylinder 38 is connected to the connecting section of the main chamber 12 and the sub-chamber 14. The rectifying cylinder 38 is vertically aligned and concentric with the pull shaft 30. The length of the rectifying cylinder 38 should be set so that the distance between the lower end of the rectifying cylinder 38 and the surface of the melt 28 during the crystal growing process is within a specific range of, for example, 5 to 100 mm. Also, the inner diameter of the rectifying cylinder 38 should be set so that the minimum distance between the inner surface of the rectifying cylinder 38 and the surface of the single crystal 36 is within a specific range of, for example, 5 to 100 mm.

On the side surface of the lower portion of the rectifying cylinder 38, a quartz port 40 for observation of the single crystal is provided in alignment with the inspection hole 12b.

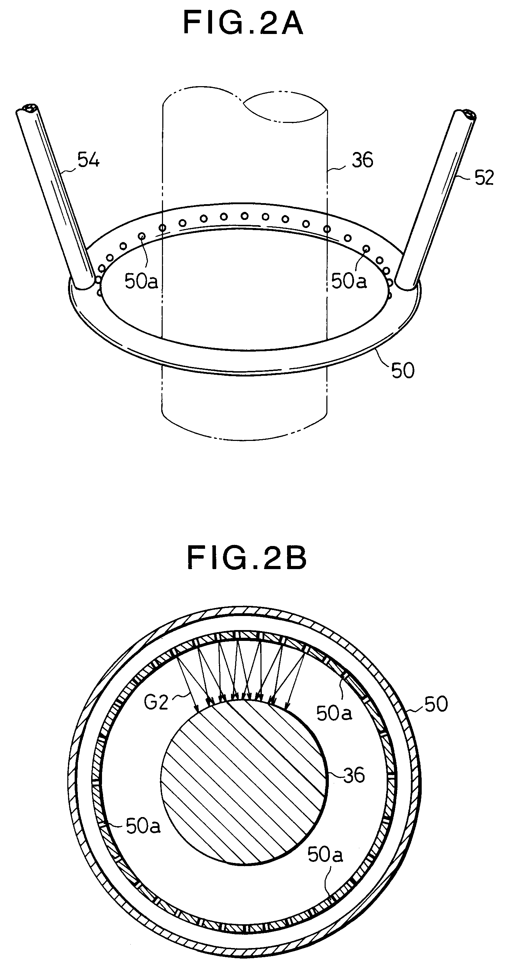

A seat 44, which projects inward in the direction of the radius, is formed at the lower end of the rectifying cylinder 38 and a quartz ring pipe 50 is mounted on the seat 44. As shown in FIG. 2A, a plurality of gas emission holes 50a are formed on the inside of the ring pipe 50 in the direction of the radius. Also, a pair of holes of diameter larger than that of the gas emission holes 50a are formed on the upper surface of the ring pipe 50 and the lower ends of the quartz gas supply pipes 52, 54 are fitted into those holes.

When the inert gas G2 is supplied into the ring pipe 50 through the gas supply pipes 52, 54, the inert gas G2 is emitted out through the gas emission holes 50a and blows upon the circumferential surface of the single crystal 36 as shown in FIG. 2B to cool the lower portion of the single crystal 36. The two point chain lines in FIG. 2B indicate the lower end openings of the gas supply pipes 52, 54.

If the diameters of the gas emission holes 50a are uniform, machining can be more easily accomplished. However, if the diameters are uniform, the flow rate of the inert gas G2 that is emitted through the gas emission holes 50a which are located closer to the gas supply pipes 52, 54 increases.

With these factors considered, in order to cool the circumferential surface of the single crystal 36 evenly, the diameters of the gas emission holes 50a are made uniform and at the same time, the pitch of the gas emission holes 50a becomes smaller as their distance increases from the lower ends of the gas supply pipes 52, 54.

As an alternative, the pitch of the gas emission holes 50a may be uniform and the circumferential surface of the single crystal 36 can still be cooled evenly by increasing the diameters of the gas emission holes 50a as their distance increases from the gas supply pipes 52, 54. Also, the present invention does not limit the number of gas supply pipes to two, it can be any number which is one or more.

For simplification, the gas supply pipe 54 shown in FIG. 2A is not illustrated in FIG. 1. The gas supply pipe 52 is led out to the outside of the main chamber 12 after passing through the gas supply pipe support portion 12c that is provided at the shoulder section of the main chamber 12. The upper ends of both gas supply pipes 52 and 54 (FIG. 2A) are connected to the gas supply pipe 56. The gas supply pipe 56 functions as an outlet pipe for the gas cooling apparatus 60.

The gas cooling apparatus 60 is provided with the heat exchanger 62 and the freezer 64. The heat exchanger 62 contains the coolant 62b inside the container 62a and the inner heat exchange coil 62c and the heat exchange coil 62d which is outside the inner heat exchange coil 62c are immersed in the coolant 62b. The gas supply pipe 66 is connected to the inlet port of the heat exchange coil 62d and the gas supply pipe 56 is connected to the outlet port of the heat exchange coil 62d and the inlet/outlet ports of the heat exchange coil 62c are connected to the freezer 64.

The coolant 62b is cooled by the freezer 64 and the inert gas is cooled by travelling inside the gas supply pipe 66 and through the heat exchange coil 62d. The inert gas travels through the gas supply pipe 56 to the gas supply pipes 52 and 54 (FIG. 2A) to enter the ring pipe 50 and then it is emitted through the gas emission holes 50a shown in FIG. 2A.

Next, the operation of the first embodiment, the structure of which is described above, is explained.

The pressure inside the chamber 10 is reduced with a vacuum pump and Ar gas is supplied from the supply port 14a into the sub-chamber 14. Then the Ar gas is drawn down and discharged from the exhaust port 12a of the main chamber 12. The pressure in the main chamber 12 should be set at, for example, 50 mbar by adjusting the supplied quantity or discharged quantity of Ar gas.

Power is supplied to the heater 24 to heat up the poly-crystal silicone inside the quartz crucible 22, to get the melt 28. By lowering the pull shaft 30, the seed crystal 34 is immersed in the melt 28 and it is then pulled up to grow the single crystal 36.

During the formation of the single crystal, the inert gas G1 flows down inside the rectifying cylinder 38, travels between the lower end of the rectifying cylinder 38 and the surface of the melt 28, and then flows out of the quartz crucible 22 after traveling between the outer surface of the collar 42 and the inner surface of the quartz crucible 22. It is then drawn down and discharged via the exhaust port 12a. The flow rate of the inert gas G1 is, for example, 80 l/min.

With this, the volatile SiO that has been generated through reaction between the melt 28 and the quartz crucible 22 is carried off in the flow of Ar gas and discharged via the exhaust port 12a. Consequently, it becomes possible to prevent the SiO from being deposited on the inner circumferential surface of the quartz crucible 22, the outer surface of the collar 42, the single crystal 36, the seed holder 32, the pull shaft 30 and the like. Also, with this flow of Ar gas, the quantity of oxygen released by the melt 20a increases to lower the oxygen concentration in the single crystal 36, resulting in reduced oxidation-induced defects and swirl defects.

In addition to the major effects presented by the rectifying cylinder 38 and the inert gas G1 as described above, the following secondary effect is produced by the rectifying cylinder 38 and the inert gas G1: as the inert gas G1 passes down to surround the single crystal 36, the single crystal 36 is cooled. Furthermore, since the collar 42 is cooled by the Ar gas while the radiant heat is absorbed by the outer surface of the graphite collar 42, the temperature of the lower portion inside the rectifying cylinder 38 is lower than it is in a structure that is not provided with the collar 42.

However, since the inert gas G1 is heated when it flows down inside the rectifying cylinder 38, the flow rate of the inert gas G1 must be sufficient to allow such a secondary effect to function adequately and it is, therefore, is not economical. Furthermore, if the flow rate of the inert gas G1 is increased, the surface of the material melt 28 becomes turbulent, and the success rate, particularly of the formation of the single crystal thin neck portion 36a that follows the seed crystal 34 is reduced.

On the other hand, during the growing of the singe crystal, the cooling inert gas G2 that has been cooled in the gas cooling apparatus 60, is emitted through the gas emission holes 50a of the ring pipe 50. Preferable flow rate for the inert gas G2 depends upon the diameter of the single crystal 36 and the temperature of the inert gas G2. Normally, preferable flow rate is 10 to 20% of that of the inert gas G1, for example, 10 l/min. is considered to be sufficient. With the cooling inert gas G2 emitted though the gas emission holes 50a, the lower portion of the single crystal 36 can be cooled efficiently and the vertical temperature gradient of the single crystal 36 near the solid/liquid interface becomes steep, thereby improving the growth rate of the single crystal 36. With this, it becomes possible to increase the diameter of the single crystal 36 or to improve the pulling speed of the single crystal 36. Also, since it is not necessary to set a high flow rate for the inert gas G1, it is possible to prevent the surface of the melt 28 from becoming turbulent under pressure of the inert gas G1 and it becomes possible to increase the success rate, particularly of the growing the thin neck portion 36a of the single crystal 36 that follows the seed crystal 34.

### Second Embodiment

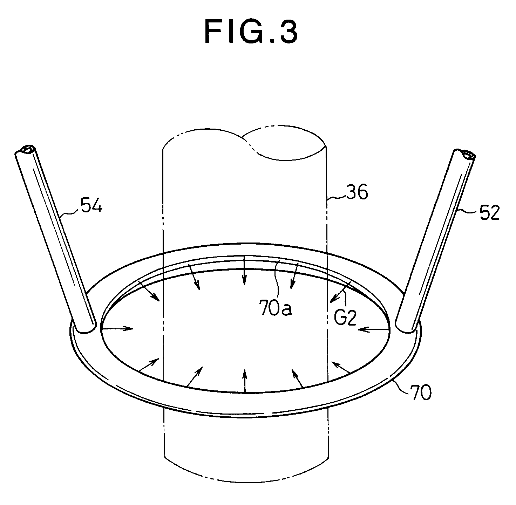

FIG. 3 shows a second embodiment of the cooling inert gas blowing apparatus.

This cooling inert gas blowing apparatus is provided with one ring slit 70a formed on the inside of the ring pipe 70 in the direction of the radius instead of a plurality of gas emission holes 50a as shown in FIG. 2A. The width of this ring-like slit 70a increases as its distance increases from the lower ends of the gas supply pipes 52, 53 and the circumferential surface of the single crystal 36 is cooled evenly with the inert gas G2 emitted from the ring slit 70a.

### Third Embodiment

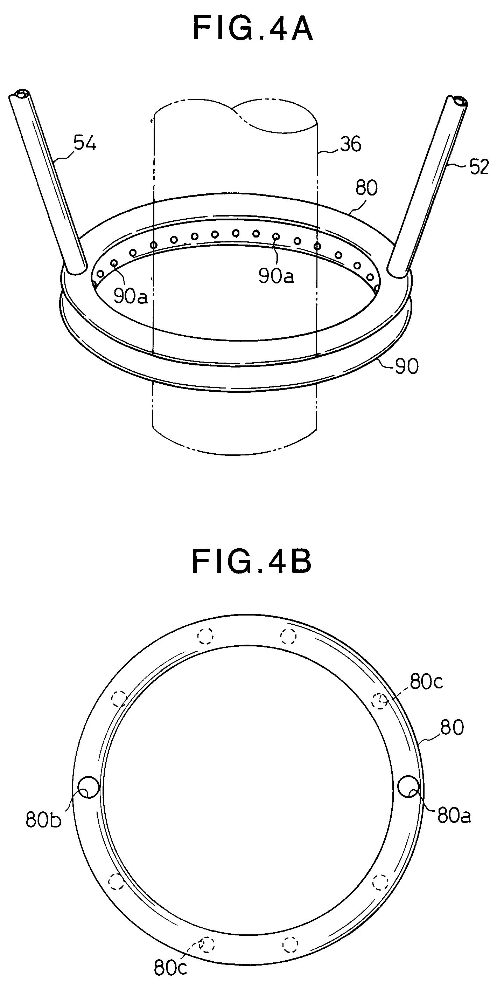

FIGs. 4A and 4B show a third embodiment of the cooling inert gas blowing apparatus. (0050)

In this cooling inert gas blowing apparatus, the ring pipe 80 and the ring pipe 90 with a plurality of gas emission holes 90a formed on the inside in the direction of the radius, are joined in a two-ply structure. The ring pipe 80 is provided with a pair of connecting holes 80a and 80b and the lower ends of the gas supply pipes 52, 54 are fitted into them. In the joining surface between the ring pipe 80 and the ring pipe 90, a plurality of communicating holes 80c whose diameter is larger than the diameter of the gas emission holes 90a are formed and the ring pipe 90 also is provided with identical communicating holes to correspond with the communicating holes 80c. The inert gas G2 travels through the communicating holes 80c and through the corresponding communicating holes in the ring pipe 90 to enter the ring pipe 90. Once in the ring pipe 90, the inert gas G2 is distributed almost evenly. With this, even if the pitch is uniform for all the gas emission holes 90a, and the diameters of the gas emission holes 90a are uniform, the circumferential surface of the single crystal can be cooled evenly and, at the same time, the design of the cooling inert gas blowing apparatus is facilitated.

Having described specific embodiments of the present invention, it is to be understood that modification and variation of the invention are possible without departing from the spirit and scope thereof.

## Claims

1. An inert gas rectifying/blowing apparatus for a single crystal pulling device which includes: a large diameter main chamber (12); a small diameter sub-chamber (14) connected to an opening at upper end of the large diameter main chamber; and a crucible (22) for containing material melt (28), the crucible being within the main chamber, whereby a single crystal (36) is grown by immersing a seed crystal (34) in the material melt and by pulling the seed crystal upwards vertically, the inert gas rectifying/blowing apparatus comprising:
a rectifying cylinder (38), an opening at upper end of which is connected to the opening at the upper end of the main chamber and which surrounds the single crystal in concentricity with the single crystal, and through which inert gas (G1) flows downward;
a ring pipe (50) provided concentrically with and inside lower end of said rectifying cylinder, said ring pipe having a plurality of holes (50a) or a slit (70a) for gas emission formed inside said ring pipe in radius direction; and
a gas supply pipe (52, 54) for supplying cooling inert gas (G2) from the outside of the chamber into said ring pipe for emission inside the main chamber.

2. An Inert gas rectifying/blowing apparatus for a single crystal pulling device according to claim 1 wherein:
said holes for gas emission (50a) formed in said ring pipe for gas emission (50) being same diameter each other, pitch of said holes being smaller as their distance increases from connecting portion of said gas supply pipe (52, 54) with said ring pipe for gas emission (50) in order to cool circumferential surface of said single crystal evenly.

3. An Inert gas rectifying/blowing apparatus for a single crystal pulling device according to claim 1 wherein:
said holes for gas emission (50a) formed in said ring pipe for gas emission (50) being same pitch each other, diameters of said holes being larger as their distance increases from connecting portion of said gas supply pipe (52, 54) with said ring pipe for gas emission in order to cool circumferential surface of said single crystal evenly.

4. An Inert gas rectifying/blowing apparatus for a single crystal pulling device according to claim 1 wherein:
said holes (90a) or said slit formed in said ring pipe for gas emission (90) are formed uniformly along inner circumference of said ring pipe in radius direction of said ring pipe for gas emission,
said gas supply pipe (52, 54) have a gas distribution ring pipe (80) of approximately the same diameter as said ring pipe for gas emission, said gas distribution ring pipe being arranged concentrically with said ring pipe (90) for gas emission and provided with a plurality of communicating holes (80c) that communicate with said ring pipe for gas emission; and a gas linear pipe being connected at its one end to said gas distribution ring pipe (80) and lead to outside of said chamber,
whereby said cooling inert gas (G2) is substantially uniformly distributed in a said ring pipe (90) for gas emission when said cooling inert gas (G2) enters said ring pipe for gas emission from said gas linear pipe (52, 54) via said gas distribution ring pipe (80).

5. An Inert gas rectifying/blowing apparatus for a single crystal pulling device according to claim 1, further comprising a collar (42) provided at lower end of said rectifying cylinder (38), cross section of which is circular and which extends upward and outward from said lower end.

6. An Inert gas rectifying/blowing apparatus for a single crystal pulling device according to claim 2, further comprising a collar (42) provided at lower end of said rectifying cylinder (38), cross section of which is circular and which extends upward and outward from said lower end.

7. An Inert gas rectifying/blowing apparatus for a single crystal pulling device according to claim 3, further comprising a collar (42) provided at lower end of said rectifying cylinder (38), cross section of which is circular and which extends upward and outward from said lower end.

8. An Inert gas rectifying/blowing apparatus for a single crystal pulling device according to claim 4, further comprising a collar (42) provided at lower end of said rectifying cylinder (38), cross section of which is circular and which extends upward and outward from said lower end.
